# EUROPEAN PATENT APPLICATION

(11) **EP 2 413 393 A2**
(43) Date of publication of application: **01.02.2012**
(21) Application number: 11156398.7
(22) Date of filing: 01.03.2011
(51) Int. Cl.: H01L 51/00

(54) **Method for manufacturing organic light emitting device and solution for organic light emitting device**

(30) Priority: 30.07.2010 JP 2010171909
(71) Applicant: Kabushiki Kaisha Toshiba, Tokyo 105-8001 (JP)
(72) Inventor: Shinjo, Yasushi, Tokyo 105-8001 (JP); Oooka, Haruhi, Tokyo 105-8001 (JP); Sawabe, Tomoaki, Tokyo 105-8001 (JP); Sugizaki, Tomoko, Tokyo 105-8001 (JP); Enomoto, Shintaro, Tokyo 105-8001 (JP)
(74) Representative: HOFFMANN EITLE

(57) **Abstract**

According to one embodiment, a method is disclosed for manufacturing an organic light emitting device (10). The organic light emitting device (10) includes an anode layer (110), a cathode layer (120), an emission layer (130) provided between the anode layer (110) and the cathode layer (120), and an intermediate layer (140) provided between the emission layer (130) and the cathode layer (120). The method can include applying a first solution containing a first organic material and a first solvent on the anode layer (110) to form the emission layer (130). The method can include applying a second solution on the emission layer (130) to form the intermediate layer (140), the second solution containing a second organic material with low molecular weight and a second solvent. The second solvent contains an acetylene alcohol-based surfactant (143) and has a solubility parameter smaller than a solubility parameter of the first solvent.

## Description

### FIELD

Embodiments described herein relate generally to a method for manufacturing an organic light emitting device and a solution for the organic light emitting device.

### BACKGROUND

An organic light emitting device such as an organic light emitting diode (OLED) is a self-luminous device and is expected to be applied to light sources in addition to display devices utilizing a wide viewing angle and high-speed response. Manufacturing processes for the organic light emitting device include vacuum evaporation process and the solution process. The solution process enables film-formation in atmospheric pressure and fabrication of large-area device as compared to the deposition method. Thus, the solution process is considered to be highly efficient in the use of material and advantageous in terms of cost.

Generally, when the organic light emitting device is manufactured by the solution process, desired characteristics cannot be obtained due to the dissolution of a lower layer during the application of an upper layer. This inhibits the practical implementation of the solution-processed organic light emitting device.

### BRIEF DESCRIPTION OF THE DRAWINGS

FIG. 1 is a flow chart illustrating a method for manufacturing an organic light emitting device according to an embodiment;
FIGS. 2A and 2B are schematic views in order of the processes, illustrating the method for manufacturing an organic light emitting device according to the embodiment;
FIG. 3 is a schematic cross-sectional view illustrating the configuration of an organic light emitting device manufactured by the method for manufacturing an organic light emitting device according to the embodiment;
FIG. 4 is scanning transmission electron microscope photographic images of samples of organic light emitting devices;
FIG. 5 is a schematic diagram illustrating a second organic material used for the method for manufacturing an organic light emitting device according to the embodiment;
FIG. 6 is a schematic diagram illustrating characteristics of the second organic material used for the method for manufacturing an organic light emitting device according to the embodiment; and
FirG. 7A to FIG. 7C are schematic diagrams illustrating second organic materials used for the method for manufacturing an organic light emitting device according to the embodiment.

### DETAILED DESCRIPTION

In general, according to one embodiment, a method is disclosed for manufacturing an organic light emitting device. The organic light emitting device includes an anode layer, a cathode layer, an emission layer provided between the anode layer and the cathode layer, and an intermediate layer provided between the emission layer and the cathode layer. The method can include applying a first solution containing a first organic material and a first solvent on the anode layer to form the emission layer. The method can include applying a second solution on the emission layer to form the intermediate layer, the second solution containing a second organic material with low molecular weight and a second solvent. The second solvent contains an acetylene alcohol-based surfactant and has a solubility parameter smaller than a solubility parameter of the first solvent

Various embodiments will be described hereinafter with reference to the accompanying drawings.

The drawings are schematic or conceptual; and the relationships between the thickness and width of portions, the proportional coefficients of sizes among portions, etc., are not necessarily the same as the actual values thereof. Further, the dimensions and proportional coefficients may be illustrated differently among drawings, even for identical portions.

In the specification of the application and the drawings, components similar to those described in regard to a drawing thereinabove are marked with the same reference numerals, and a detailed description is omitted as appropriate.

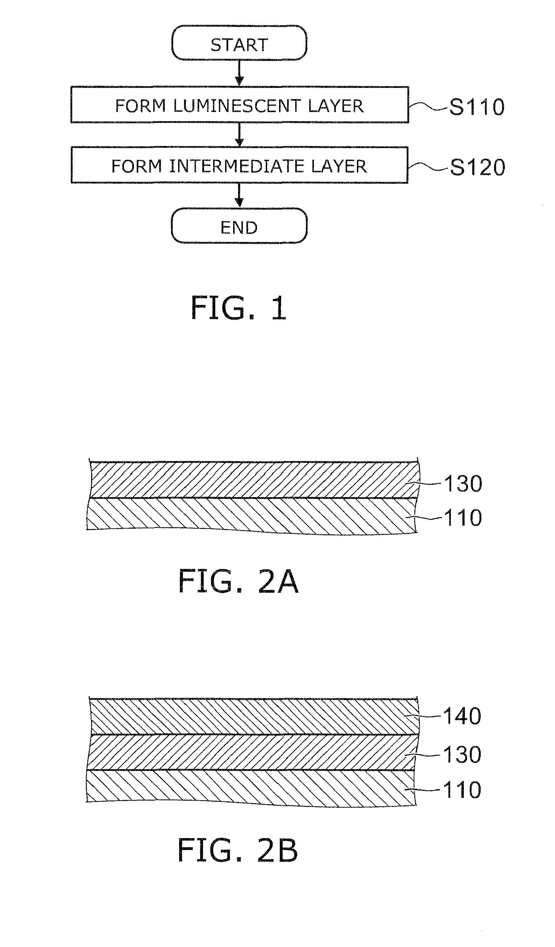

FIG. 1 is a flow chart illustrating a method for manufacturing an organic light emitting device according to an embodiment.
FIGS. 2A and 2B are schematic views in order of the processes, illustrating the method for manufacturing an organic light emitting device according to the embodiment.

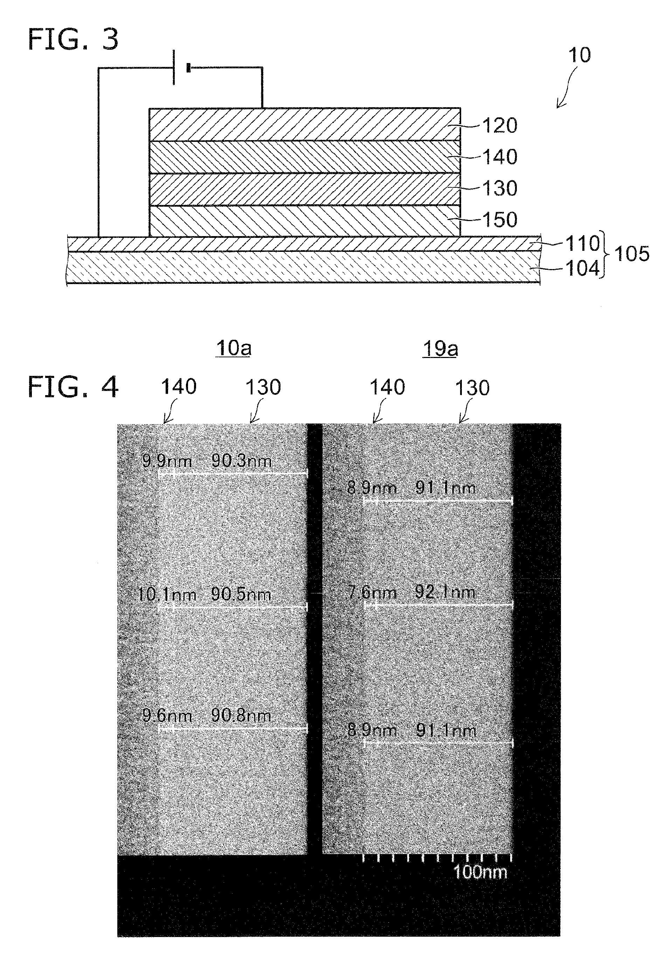

FIG. 3 is a schematic cross-sectional view illustrating the configuration of an organic light emitting device manufactured by the method for manufacturing an organic light emitting device according to the embodiment.

First, an organic light emitting device manufactured with the method for manufacturing according to the embodiment will now be described with reference to FIG. 3.

As shown in FIG. 3, an organic light emitting device 10 manufactured by the method for manufacturing an organic light emitting device according to the embodiment includes an anode layer 110, a cathode layer 120, an emission layer 130 provided between the anode layer 110 and the cathode layer 120 and containing an organic material, and an intermediate layer (electron transport layer 140) provided between the emission layer 130 and the cathode layer 120.

The intermediate layer includes a layer in contact with a surface of the emission layer 130 on the cathode layer 120 side. Hereinbelow, the case is described where the electron transport layer 140 is used as the intermediate layer. The embodiment is not limited thereto, but a layer other than the electron transport layer 140 may be used to the extent that the intermediate layer includes a layer in contact with the surface of the emission layer 130 on the cathode layer 120 side.

In the specific example, the organic light emitting device 10 further includes a hole injection layer 150 provided between the anode layer 110 and the emission layer 130. The hole injection layer 150 is provided as necessary and can be omitted. A hole trasnport layer may be provided between the anode layer 110 and the emission layer 130.

In the specific example, the anode layer 110 is provided on a supporting substrate 104. An anode-side substrate 105 includes the supporting substrate 104 and the anode layer 110. A glass substrate, for example, is used as the supporting substrate 104.

As the anode layer 110, for example, an electrically conductive material having the trancelucency to the light emitted from the emission layer 130 is used. As the anode layer 110, for example, an electrically conductive oxide such as tin oxide, zinc oxide, indium oxide, and indium tin oxide (ITO) is used.

However, the embodiment is not limited thereto, but a material opaque to (including blocking) the light emitted from the emission layer 130 may be used as the anode layer 110. For example, in those cases where the cathode layer 120 has the trancelucency to the light emitted from the emission layer 130, a material opaque to the light emitted from the emission layer 130 may be used as the anode layer 110.

The hole injection layer 150 injects holes from the anode layer 110 toward the emission layer 130. Poly(3,4-ethylenedioxythiophene) poly(styrene sulfonate) (PEDOT:PSS), for example, is used as the hole injection layer 150.

The emission layer 130 contains an organic light-emitting material. The organic light-emitting material contains, for example, at least one of an organic fluorescent material, an organic phosphorescent material, and an organometallic complex.

A host compound doped with the organic light-emitting material may be used for the emission layer 130. For example, a host compound having at least one of an electron transport property and a hole transport property and doped with the organic light-emitting material may be used for the emission layer 130. At least one of an electron transportable material and a hole transportable material may be used as the host compound for the emission layer 130. Thereby, at least one of the electron transport property and the hole transport property in the emission layer 130 can be enhanced.

As the organic light-emitting material for the emission layer 130, for example, at least one of a phosphorescent material containing an iridium complex (Ir(ppy)₃, FIrPic, Ir(ppy)₂(acac), and Ir(hffpy)₂(acac)) or the like (molecular weights of them: 599 to 694) and a fluorescent material containing perylene, a coumarin derivative, quinacridone, or the like (molecular weights of them: 252 to 995) is used.

As the host material for the emission layer 130, for example, 4,4'-bis(carbazol-9-yl)-biphenyl (CBP, molecular weight: 484), polyvinylcarbazole (PVK), and the like are used.

As the electron transportable material used for the emission layer 130 as necessary, for example, 1,3-bis[5-(4-tert-butylphenyl)-1,3,4-oxadiazol-2-yl] benzene (OXD-7) and the like are used.

As the hole transportable material used for the emission layer 130 as necessary, for example, 2-(4-biphenylyl)-5-(4-tert-butylphenyl)-1,3,4-oxadiazole (PBD, molecular weight: 354) and the like are used.

The electron transport layer 140 transports electrons injected from the cathode layer 120 toward the emission layer 130. The electron transport layer 140 contains an electron transportable material. The electron transport layer 140 may further function as a hole blocking layer for confining holes injected from the anode layer 110 in the emission layer 130.

A low-molecular-weight organic material (an organic material with low molecular weight) is used for the electron transport layer 140. The low-molecular-weight organic material is an organic material with a molecular weight of not more than 5000.

The molecular weight of the organic material (the second organic material described later) used for the electron transport layer 140 is measured by gas chromatography.

The organic material used for the electron transport layer 140 is preferably a material soluble in a solvent of which the solubility parameter described later is small.

For the electron transport layer 140, for example, at least one selected from the group consisting of 2-(4-biphenylyl)-5-(4-tert-butylphenyl)-1,3,4-oxadiazole (PBD, molecular weight: 354), 2,5-bis(1-naphthyl)-1,3,4-oxadiazole (BND, molecular weight: 322), 2,9-dimethyl-4,7-diphenyl-1,10-phenanthroline (BCP (bathocuproin), molecular weight: 360), tris(2,4,6-trimethyl-3-(pyridin-3-yl)phenyl)borane (3TPYMB, molecular weight: 599), 1,3-bis[3,5-di(pyridin-3-yl)phenyl] benzene (BmPyPhB, molecular weight: 539), 3,3',5,5'-tetra[(m-pyridyl)-phen-3-yl]biphenyl (BP4mPy, molecular weight: 767), and 1,3,5-tri[(3-pyridyl)-phen-3-yl]benzene (TmPyPB, molecular weight: 538) is used.

As the cathode layer 120, a simple substance selected from the group consisting of lithium, sodium, potassium, rubidium, cesium, magnesium, calcium, strontium, barium, aluminum, boron, copper, silver, and gold or a mixture (an alloy etc.) including two or more selected from the group is used. In addition, a layer of a simple substance selected from the group or a stacked film of layers of mixtures may be used as the cathode layer 120. Furthermore, as the cathode layer 120, a structure body is used in which a layer of lithium fluoride, lithium oxide, calcium fluoride, cesium fluoride, and the like is further stacked on the stacked film mentioned above. Tetrahydroaluminate, cesium carbonate, and an acetylacetone complex containing lithium, calcium, or the like are used as the cathode layer 120, and the cathode layer 120 can be formed using wet processing.

The organic light emitting device 10 having such a configuration is manufactured by such a manufacturing method as follows.

As shown in FIG. 1 and FIG. 2A, a first solution containing a first organic material and a first solvent is applied on the anode layer 110 to form an emission layer (step S110).

As shown in FIG. 1 and FIG. 2B, a second solution containing a second organic material and a second solvent is applied on the emission layer 130 to form the electron transport layer 140 (intermediate layer) (step S120).

The second organic material is a low-molecular-weight organic material (an organic material with low molecular weight). The second organic material has a molecular weight of not more than 5000. The second solvent contains an acetylene alcohol-based surfactant. The second solvent has a solubility parameter (SP value) smaller than the solubility parameter of the first solvent.

The solution process includes casting method, spin coating method, ink-jet printing method, dipping method, spray coating method, slit coating method, meniscus coating method, gravure printing method, offset printing method, flexographic printing method, screen printing method, and the like.

The acetylene alcohol-based surfactant contains a compound having an acetylene alcohol structure having a hydrophilic group and a hydrophobic group in the chemical structure.

The solubility parameter (SP value) is used as a measure expressing intermolecular force.

The SP value is expressed by, for example, 6 = (Eco/V)^{½} defined by Hildebrand, where E_{co} is the molar evaporation energy (cal/mol), and V is the molar volume (cm³/mol).

δ is found from the relation of E_{co} = ΔH - RT based on the property values, for example, where ΔH is the change in enthalpy (cal/mol) due to evaporation, R is the gas constant (cal/mol), and T is temperature (K).

Furthermore, δ can be broken down into three terms to be expressed as δ² = δd² + δp² + δh². δd, δp, and δh are SP values corresponding to a dispersion force term, an inter-dipole force term, and a hydrogen bond force term, respectively.

In general, it is empirically known that the solubility of two materials increases as the difference between the SP values of the two materials decreases. The SP value can be used as an indicator of the solubility of organic substances.

In regard to methods for calculating the SP value, the SP value can be found from the evaporation energy (Δei) and the molar volume (Δvi) of an atom or atomic group of a chemical structure. According to this, the SP value is expressed by δ = (ΣΔei/ΣΔvi)^{½}.

The SP value (δm) of a mixed solvent containing a first solvent and a second solvent is found by δm = δ1ϕ1 + δ2ϕ2, where δ1 is the SP value of the first solvent, ϕ1 is the volume fraction of the first solvent, δ2 is the SP value of the second solvent, and ϕ2 is the volume fraction of the second solvent.

In the embodiment, the SP value of the second solvent used for the formation of the electron transport layer 140 is smaller than the SP value of the first solvent used for the formation of the emission layer 130. Therefore, the emission layer 130 is substantially insoluble in the second solvent, and the possibility can be decreased that the emission layer 130 is dissolved by the second solvent during forming the electron transport layer 140. Thus, the manufacturing method suppresses the dissolution of a lower layer (the emission layer 130) during the application of an upper layer (the electron transport layer 140). Thereby, an organic light emitting device having desired characteristics can be easily manufactured at low cost, and a large-sized organic light emitting device can be easily manufactured.

The electron transport layer 140 may be made of a polymeric material or a low-molecular-weight material. Although polymeric materials have good film forming property, electrical characteristics such as the mobility are generally lower than those of low-molecular-weight materials.

In view of this, the inventors carried out experiments to investigate various methods in which the electron transport layer 140 of a low-molecular-weight material with good electrical characteristics is formed on the emission layer 130 by the solution process. The configuration according to the embodiment has been obtained based on new findings obtained from the results of the experiments.

In the case where the SP value of the second solvent used for the second solution of the upper layer (the electron transport layer 140) has a value outside the range of the SP value of a solvent (i.e., the first solvent) capable of dissolving the lower layer (the emission layer 130), it is considered that the lower layer is not dissolved in the second solvent when the upper layer is applied on the lower layer. In other words, when the second solvent of the upper layer has an SP equivalent to that of the first solvent of the lower layer, the lower layer is dissolved by the second solvent of the upper layer. It is considered that the dissolution of the lower layer due to the second solvent of the upper layer can be suppressed when the SP value of the second solvent of the upper layer is smaller than the SP value of the first solvent of the lower layer or when the SP value of the second solvent of the upper layer is larger than the SP value of the first solvent of the lower layer.

The SP value of the material (the first organic material) of the emission layer 130 of the organic light emitting device is generally not less than about 8.0 (cal/cm³)^{½} and not more than about 10 (cal/cm³)^{½}.

Solvents having SP values larger than 10 (cal/cm³)^{½} include a hydrophilic solvent such as alcohol. In the case where such a hydrophilic solvent is used as the second solvent, the characteristics of the organic light emitting device are easily degraded due to water and the like contained in the second solvent.

In view of this, the inventors selected a solvent having an SP value smaller than the SP value of the first solvent of the lower layer as the second solvent of the upper layer. The solvent with a small SP value is hydrophobic and suppresses bad effects of water like the above.

It has been found out that a crystalization of second organic material occurs in the case where a second solvent with a small SP value and a second organic material with low molecular weight are combined.

In the case where a solution is applied in which a second solvent with a small SP value and a second organic material of a high molecular are combined, the film applied has high amorphous properties and easily becomes a smooth film during drying after the application, causing little problem. However, as described above, in the case where a polymeric material is used as the second organic material, the electrical characteristics are low and desired characteristics cannot be obtained.

In contrast, if a solution is applied in which a second solvent with a small SP value and a second organic material with low molecular weight are combined, the crystal is easily deposited during the process of the solution being dried to be concentrated. If the device is fabricated in a state where a piece of the crystalization remains, a short may be caused.

The inventors carried out various experiments on configuration in which the deposition of a crystal is not generated even in the case where a solvent with a small SP value and a second organic material with low molecular weight are combined. As a result, it has been found out that the crystalization of the second organic material with low molecular weight can be suppressed by adding the acetylene alcohol-based surfactant to the solvent with a small SP value.

The configuration of the embodiment has been obtained based on this result.

That is, the high electrical characteristics of the electron transport layer 140 can be maintained by using an organic material with a molecular weight of not more than 5000 as the second organic material.

Furthermore, by using a material having an SP value smaller than the SP value of the first solvent as the second solvent, the emission layer 130 is not dissolved in the second solvent, and further the degradation of the characteristics of the device due to water and the like can be suppressed. Moreover, since the second solvent contains the acetylene alcohol-based surfactant, the crystalization of the second organic material with low molecular weight (e.g. an electron transportable material) can be suppressed even if the second solvent with a small SP value is used.

As the first solvent used for the formation of the emission layer 130, at least one selected from the group consisting of xylene (SP value = 8.75 to 9.0), toluene (SP value = 8.9), tetrahydronaphthalene (SP value = 9.5), chlorobenzene (SP value = 9.6), dichlorobenzene (SP value = 9.9), cyclohexanone (SP value = 9.9), chloroform (SP value = 9.2), dichloroethane (SP value = 9.9), and tetrahydrofuran and a mixture containing two or more selected from the group may be used.

As the second solvent used for the formation of the electron transport layer 140, at least one of a saturated hydrocarbon solvent such as hexane (SP value = 7.2), heptane (SP value = 7.5), octane (SP value = 7.5), nonane (SP value = 7.6), and decane (SP value = 7.7), an unsaturated hydrocarbon solvent such as cyclohexane (SP value = 8.2), and an aromatic hydrocarbon solvent such as xylene (SP value = 8.75 to 9.0), toluene (SP value = 8.9), and tetrahydronaphthalene (SP value = 9.5) may be used.

A material with a small SP value is used as the second solvent. A material with an SP value smaller than the SP value of the first solvent is preferably selected as the second solvent.

The acetylene alcohol-based surfactant is a compound functioning as a surfactant and having volatile properties. As the acetylene alcohol-based surfactant, for example, at least one selected from the group consisting of 3-methyl-1-butyn-3-ol (SP value = 12.3, Boiling point = 103.6°C), 3-methyl-1-pentyn-3-ol (SP value = 11.4, Boiling point = 121.4°C), 3,5-dimethyl-1-hexyn-3-ol (SP value = 10.0, Boiling point = 150°C), 2,5-dimethyl-3-hexyn-2,5-diol (SP value = 10.3, Boiling point = 205°C), and 3,6-dimethyl-4-octyn-3,6-diol (SP value = 9.3, Boiling point = 250°C) may be used.

The SP value of the acetylene alcohol-based surfactant is calculated from the relation of δ = (ΣΔei/ΣΔvi)^{½} described above.

The second solvent contains the acetylene alcohol-based surfactant and the solvent with a small SP value mentioned above. The SP value of the second solvent, which is a mixed solvent after mixing the acetylene alcohol-based surfactant and the solvent with a small SP value, is set smaller than the SP value of the first solvent.

The concentration of the acetylene alcohol-based surfactant in the second solvent is set to, for example, 0.1 vol% to 5 vol%. If the concentration is lower than 0.1 vol%, for example, a crystallization of the second organic material cannot be suppressed. If the concentration is higher than 5 viol%, a minute amount of water contained in the alcohol may adversely affect the material of the emission layer and the like.

The first organic material contained in the first solution for the formation of the emission layer 130 preferably contains a polymeric material with a molecular weight of not less than 20,000. By the first organic material containing a polymeric material with a molecular weight of not less than 20,000, for example, the first organic material is dissolved less easily by the second solvent to widen various permissible windows in manufacturing conditions and materials used, and the organic light emitting device can be manufactured more stably.

When a polymeric material is dissolved in a solvent, the polymeric material swells in the solvent, goes through a gel state, and is then dissolved. Hence, the polymeric material used for the first organic material is affected less easily by the second solvent. The content ratio of the polymeric material used as the first organic material is preferably not less than 50% by weight. By setting the content ratio of the polymeric material used as the first organic material to not less than 50%, the stability of the emission layer 130 to the second solvent is enhanced more.

It is assumed that the molecular weight of the first organic material is defined by a polystyrene-reduced weight average molecular weight measured by gel permeation chromatography.

As another method for forming the upper layer of an organic material by the solution process on the lower layer of an organic material formed by the solution process, a method of performing insolubilization treatment by cross-linking is given. This method, however, complicates the manufacturing processes and has a restriction such as needing to introduce a cross-linking group.

In contrast, the manufacturing method according to the embodiment is simple in process, does not have a restriction such as needing to introduce a special structure such as a cross-linking group, and is therefore highly practical.

An organic light emitting device of a practical example according to the embodiment will now be described.

As the anode-side substrate 105, a structure was used in which ITO was film-formed with a thickness of 100 nm (nanometers) as the anode layer 110 on the supporting substrate 104 of a glass with a size of 25 mm (millimeters) x 25 mm x 0.7 mm.

Ultrasonic cleaning with a cleaning agent was performed on the anode-side substrate 105, and ultrapure water was used to perform running water washing. After that, isopropyl alcohol (IPA) was used to perform immersion ultrasonic cleaning, followed by drying. Then, UV ozone irradiation was performed for ten minutes to decompose the residual organic substances at the surface.

A PEDOT: PSS solution (CH8000 manufactured by H. C. Starck-V TECH Co.) that forms the hole injection layer 150 was applied on the anode layer 110 by spin coating, followed by drying on a hot plate at 200°C for five minutes to form the hole transport layer 150. The hole injection layer 150 has a thickness of about 60 nm.

The first solution that forms the emission layer 130 was applied on the hole transport layer 150.

The first solution contains the first organic material and the first solvent. The first organic material contains Poly(9-vinylcarbazole) PVK (molecular weight: 400,000), which is a host compound, OXD-7, which is an electron transportable compound, and FIrPic and Ir(hflpy)₂(acac), which are guest compounds. Chlorobenzene was used as the first solvent. 67 mg of PVK, 30 mg of OXD-7, 3 mg of FIrPic, and 0.2 mg of Ir(hflpy)₂(acac) were dissolved in the chlorobenzene to make the entire first solution 8.35 g. The solid content concentration in the first solution is 1.2 wt% (weight percent).

The first solution mentioned above was applied on the hole injection layer 150 by spin coating, followed by drying on a hot plate at 80°C for 30 minutes to form the emission layer 130. The emission layer 130 has a thickness of about 90 nm.

The second solution that forms the electron transport layer 140 was applied on the emission layer 130.

The second solution contains the second organic material and the second solvent. 3TPYMB, which is an electron transportable material, was used as the second organic material. 3TPYMB is a low-molecular-weight material. The second solvent contains Surfynol™ 61 (manufactured by Nissin Chemical Co., Ltd.), which is the acetylene alcohol-based surfactant, and octane. The volume ratio of the acetylene alcohol-based surfactant:octane in the second solvent is 1:99. 100 mg of 3TPYMB was dissolved in the second solvent to make the entire second solution 10 g. The solid content concentration in the second solution is 1.0 wt%.

The second solution mentioned above was applied on the emission layer 130 by spin coating, followed by drying on a hot plate at 80°C for 30 minutes to form the electron transport layer 140. The electron transport layer 140 has a thickness of about 10 nm.

A CsF layer was deposited on the electron transport layer 140 in a vacuum of 10⁻⁴ Pa (Pascal) to 10⁻⁵ Pa. The temperature of the anode-side substrate 105 during the deposition is room temperature. The thickness of the CsF layer was about 1 nm.

Aluminum was deposited on the CsF layer in a state where a mask having patterned openings was provided. The aluminum layer has a thickness of about 150 nm. The region in which the aluminum layer opposes the ITO layer corresponds to an emission region and the area of the emission region is 2 mm x 2 mm. The stacked layer of the CsF and the aluminum corresponds to the cathode layer 120.

Thereby, the organic light emitting device 10 illustrated in FIG. 3 was fabricated. The organic light emitting device 10 fabricated was sealed in a drying nitrogen box.

The SP value of the first solvent (chlorobenzene) is 9.6. The SP value of the second solvent containing the octane and the acetylene alcohol-based surfactant is calculated using the relation of δ = (ΣΔei/Σvi)^{½} described above. The SP value of the second solvent is lower than the SP value of the first solvent.

On the other hand, to investigate the solubility of the each component in the first solvent against the second solvent, PVK, OXD-7, FIrPic, and Ir(hflpy)₂(acac) were added each at 0.2 wt% to the second solvent mentioned above. The solutions were allowed to stand at room temperature for 12 hours. After that, the solutions were observed by eye, and it was found that a powdery solid was adhered to the bottom of the bottle in each of the solutions and the solid was apparently opaque. This has led to the conclusion that each material contained in the first organic material is substantially insoluble in the second solvent.

On the other hand, as a reference example, an organic light emitting device 19 (not shown) was fabricated in which the electron transport layer 140 was formed by the deposition method on the emission layer 130 formed similarly to the foregoing. In the organic light emitting device 19, 3TPYMB was deposited on the emission layer 130 to form the electron transport layer 140, and the cathode layer 120 of a stacked layer of CsF layer and aluminum was formed thereon as in the case of the organic light emitting device 10.

FIG. 4 is scanning transmission electron microscope photographic images of samples of organic light emitting devices.

More specifically, FIG. 4 shows scanning transmission electron microscope (STEM) photographic images of a sample 10a (a sample according to the embodiment) that includes the emission layer 130 and the electron transport layer 140 fabricated by a similar method to the organic light emitting device 10 according to the practical example and a sample 19a (a sample of the reference example) that includes the emission layer 130 and the electron transport layer 140 fabricated by a similar method to the organic light emitting device 19 of the reference example.

As shown in FIG. 4, in the sample 19a of the reference example, the electron transport layer 140 is formed on the emission layer 130 by the vacuum evaporation method, a clear distinction can be made between the emission layer 130 and the electron transport layer 140, and the emission layer 130 and the electron transport layer 140 are separated.

As shown in FIG. 4, also in the sample 10a according to the embodiment, a clear distinction can be made between the emission layer 130 and the electron transport layer 140 as in the case of the sample 19a of the reference example. In the sample 10a according to the embodiment, although the electron transport layer 140 is formed by the solution process on the emission layer 130 formed by the solution process, the emission layer 130 and the electron transport layer 140 are separated. In the sample 10a, the possibility is decreased that the emission layer 130 is dissolved in the second solvent contained in the electron transport layer 140 when the electron transport layer 140 is applied on the emission layer 130.

The characteristics of the organic light emitting device 10 according to the embodiment were investigated, and the current efficiency of 41.9 cd/A and the luminous efficiency of 26.3 Im/W at a luminance of 100cd/m² was obtained. The maximum current efficiency and the maximum luminous efficiency was 42.4cd/A and 35.3lm/W, respectively.

In the organic light emitting device 19 of the reference example, 40.4 cd/A was obtained at the time of a luminance of 100 cd/m², and the luminous efficacy was 27.0 Im/W. 41.2 cd/A was obtained at the time of the maximum luminance, and the luminous efficacy at that time was 40.6 Im/W.

Thus, the organic light emitting device 10 according to the embodiment, which used the solution process to form the electron transport layer 140, has achieved equivalent characteristics to the organic light emitting device 19 of the reference example, which used the deposition method.

Thus, the manufacturing method of the practical example according to the embodiment suppressed the dissolution of the lower layer (the emission layer 130) during the application of the upper layer (the electron transport layer 140), and has provided an organic light emitting device of good characteristics.

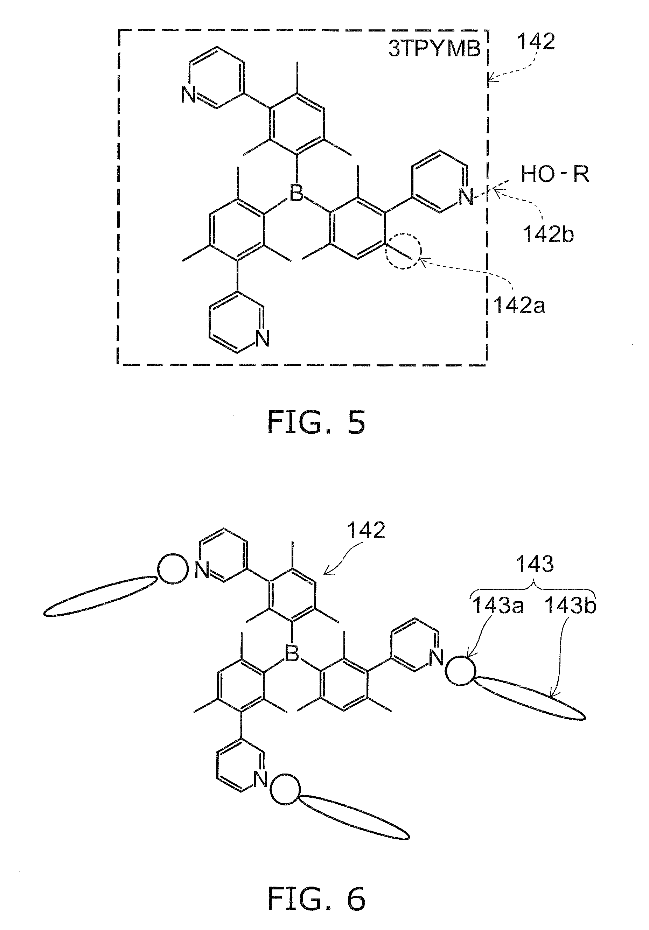

FIG. 5 is a schematic diagram illustrating a second organic material used for the method for manufacturing an organic light emitting device according to the embodiment.

FIG. 6 is a schematic diagram illustrating characteristics of a second organic material used for the method for manufacturing an organic light emitting device according to the embodiment.

FIG. 5 illustrates the structure of 3TPYMB used as the second organic material 142. FIG. 6 illustrates the interaction between 3TPYMB and an acetylene alcohol-based surfactant 143 in a model way.

It is considered that 3TPYMB has a high affinity to alcohol due to hydrogen bonds 142b.

As shown in FIG. 6, when 3TPYMB (the second organic material 142) and the acetylene alcohol-based surfactant 143 are mixed, it is considered that a hydrophilic portion 143a of the acetylene alcohol-based surfactant 143 comes close or adheres to a nitrogen element of 3TPYMB and a hydrophobic portion 143b of the acetylene alcohol-based surfactant 143 moves away from 3TPYMB.

Therefore, it is considered that a structure body is formed in which 3TPYMB (the second organic material 142) is surrounded by the acetylene alcohol-based surfactant 143 and the hydrophobic portion 143b of the acetylene alcohol-based surfactant 143 is placed on the outside of 3TPYMB (the second organic material 142). The structure body in which the hydrophobic portion 143b is placed on the outside probably has a high solubility in the second solvent with a small SP value. Consequently, it is considered that 3TPYMB surrounded by the acetylene alcohol-based surfactant 143 suppresses the crystallization also in the second solvent with a small SP value.

BmPyPhB, BP4mPy, and TmPyPB are given as examples of the second organic material 142 having such characteristics.

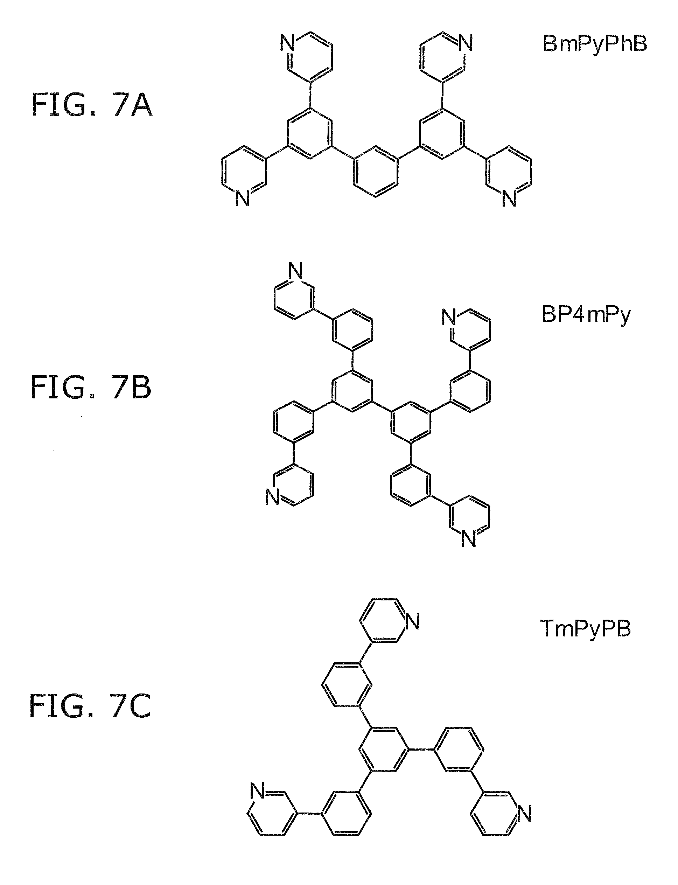

FIG. 7A to FIG. 7C are schematic diagrams illustrating second organic materials used for the method for manufacturing an organic light emitting device according to the embodiment.

FIG. 7A, FIG. 7B, and FIG. 7C illustrate the structures of BmPyPhB, BP4mPy, and TmPyPB, respectively.

As shown in these drawings, also in BmPyPhB, BP4mPy, and TmPyPB, a structure body is probably formed in which each of BmPyPhB, BP4mPy, and TmPyPB is surrounded by the acetylene alcohol-based surfactant 143 and the hydrophobic portion 143b of the acetylene alcohol-based surfactant 143 is placed on the outside. Thereby, the deposition of a crystal is suppressed also in the second solvent with a small SP value.

A second embodiment is a solution for an organic light emitting device for forming the electron transport layer by the solution process on the emission layer of the organic light emitting device.

The solution for an organic light emitting device contains an organic material with low molecular weight and a solvent containing an acetylene alcohol-based surfactant. The molecular weight of the organic material mentioned above is not more than 5000.

The organic material contains at least one selected from the group consisting of 2-(4-biphenylyl)-5-(4-tert-butylphenyl)-1,3,4-oxadiazole, 2,5-bis(1-naphthyl)-1,3,4-oxadiazole, 2,9-dimethyl-4,7-diphenyl-1,10-phenanthroline, tris(2,4,5-trimethyl-3-(pyridin-3-yl)phenyl)borane, 1,3-bis[3,5-di(pyridin-3-yl)phenyl]benzene, 3,3',5, 5'-tetra[(m-pyridyl)-phen-3-yl]biphenyl,and 1,3,5-tri[(3-pyridyl)-phen-3-yl] benzene.

The acetylene alcohol-based surfactant mentioned above contains at least one selected from the group consisting of 3-methyl-1-butyn-3-ol, 3-methyl-1-pentyn-3-ol, 3,5-dimethyl-1-hexyn-3-ol, 2,5-dimethyl-3-hexyn-2,5-diol, and 3,6-dimethyl-4-octyn-3,6-diol.

The solvent mentioned above contains at least one selected from the group consisting of hexane, heptane, octane, nonane, decane, cyclohexane, xylene, toluene, and tetrahydronaphthalene.

The solution can suppress the dissolution of the lower layer (the emission layer 130) when the solution is applied in order to form the electron transport layer 140, and allows an organic light emitting device with desired characteristics to be manufactured by the solution process.

The method for manufacturing an organic light emitting device according to the embodiment can be applied to the manufacture of arbitrary organic light emitting devices for applications such as display devices and lightings.

The embodiment can provide a method for manufacturing an organic light emitting device suppressing the dissolution of the lower layer during the application of the upper layer and a solution for an organic light emitting device.

Hereinabove, embodiments of the invention are described with reference to specific examples. However, the invention is not limited to these specific examples. For example, one skilled in the art may appropriately select specific configurations of components of organic light emitting devices such as anode layers, cathode layers, emission layers, intermediate layers, electron transport layers, hole injection layers, hole transport layers, and substrates and components used for manufacturing methods such as organic materials, surfactants, and solvents from known art and similarly practice the invention. Such practice is included in the scope of the invention to the extent that similar effects thereto are obtained.

Further, any two or more components of the specific examples may be combined within the extent of technical feasibility; and such combinations are included in the scope of the invention to the extent that the purport of the invention is included.

Moreover, all methods for manufacturing an organic light emitting device and solutions for an organic light emitting device practicable by an appropriate design modification by one skilled in the art based on the methods for manufacturing an organic light emitting device and the solutions for an organic light emitting device described above as embodiments of the invention also are within the scope of the invention to the extent that the purport of the invention is included.

Furthermore, various alterations and modifications within the spirit of the invention will be readily apparent to those skilled in the art. All such alterations and modifications should be seen as within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A method for manufacturing an organic light emitting device (10),
the organic light emitting device (10) including an anode layer (110), a cathode layer (120), an emission layer (130) provided between the anode layer (110) and the cathode layer (120), and an intermediate layer (140) provided between the emission layer (130) and the cathode layer (120),
the method comprising:
applying a first solution containing a first organic material and a first solvent on the anode layer (110) to form the emission layer (130); and
applying a second solution on the emission layer (130) to form the intermediate layer (140), the second solution containing a second organic material with low molecular weight and a second solvent, the second solvent containing an acetylene alcohol-based surfactant (143) and having a solubility parameter smaller than a solubility parameter of the first solvent.

2. The method according to claim 1, wherein the emission layer (130) is insoluble in the second solvent.

3. The method according to any of claim 1 and claim 2, wherein the second organic material contains at least one selected from the group consisting of 2-(4-biphenylyl)-5-(4-tert-butylphenyl)-1,3,4-oxadiazole, 2,5-bis(1-naphthyl)-1,3,4-oxadiazole, 2,9-dimethyl-4,7-diphenyl-1,10-phenanthroline, tris(2,4,5-trimethyl-3-(pYridin-3-yl)phenyl)borane, 1,3-bis[3,5-di(pyridin-3-yl)phenyl] benzene, 3,3',5,5'tetra[(m-pyridyl)-phen-3-yl] biphenyl, and 1,3,5-tri[(3-pyridyl)-phen-3-yl] benzene.

4. The method according to any of claims 1-3, wherein the acetylene alcohol-based surfactant contains at least one selected from the group consisting of 3-methyl-1-butyn-3-ol, 3-methyl-1-pentyn-3-ol, 3,5-dimethyl-1-hexyn-3-ol, 2,5-dimethyl-3-hexyn-2,5-diol, and 3,6-dimethyl-4-octyn-3,6-diol.

5. The method according to any of claims 1-4, wherein the second solvent contains at least one selected from the group consisting of hexane, heptane, octane, nonane, decane, cyclohexane, xylene, toluene, and tetrahydronaphthalene.

6. The method according to any of claims 1-5, wherein the first solvent contains at least one selected from the group consisting of xylene, toluene, tetrahydronaphthalene, chlorobenzene, dichlorobenzene, cyclohexanone, chloroform, dichloroethane, and tetrahydrofuran.

7. The method according to any of claims 1-6, wherein the first organic material contains a polymeric material with a molecular weight of not less than 20,000.

8. The method according to claim 7, wherein a content ratio by weight of the polymeric material in the first organic material is not less than 50%.

9. The method according to any of claims 1-8, wherein the second organic material has a molecular weight of not more than 5000.

10. The method according to any of claims 1-9, wherein a concentration of the acetylene alcohol-based surfactant (143) in the second solvent is not less than 0.1 volume percent and not more than 5 volume percent.

11. The method according to any of claims 1-10, wherein the acetylene alcohol-based surfactant (143) contains a compound having an acetylene alcohol structure having a hydrophilic group and a hydrophobic group.

12. The method according to any of claims 1-11, wherein a solubility parameter of the first organic material is not less than 8.0 (cal/cm³)^{½} and not more than 10 (cal/cm³)^{½}.

13. The method according to any of claims 1-12, wherein a solubility parameter of the first solvent is not less than 8.75 (cal/cm³)^{½} and not more than 9.9 (cal/cm³)^{½}.

14. The method according to claim 13, wherein a solubility parameter of the second solvent is not less than 7.2 (cal/cm³)^{½} and not more than 9.5 (cal/cm³)^{½}.

15. The method according to any of claims 1-14, wherein the intermediate layer (140) has an electron transport property.

16. The method according to any of claims 1-15, wherein the first organic material contains at least one of an iridium complex, perylene, a coumarin derivative, and quinacridone.

17. The method according to any of claims 1-16, wherein the first organic material contains at least one of 4,4'-bis(carbazol-9-yl)-biphenyl and polyvinylcarbazole.

18. The method according to any of claims 1-17, wherein the applying the first solution and the applying the second solution include using at least one of a casting method, a spin coating method, an ink-jet printing method, a dipping method, a spray coating method, a slit coating method, a meniscus coating method, a gravure printing method, an offset printing method, a flexographic printing method, and a screen printing method.

19. A solution for an organic light emitting device for forming an electron transport layer on an emission layer (130) of an organic light emitting device (10) by an solution process,
the solution comprising:
an organic material with low molecular weight; and
a solvent containing an acetylene alcohol-based surfactant (143),
the organic material containing at least one selected from the group consisting of 2-(4-biphenylyl)-5-(4-tert-butyiphenyl)-1,3,4-oxadiazole, 2,5-bis(1-naphthyl)-1,3,4-oxadiazole, 2,9-dimethyl-4,7-diphenyl- 1,10-phenanthroline, tris(2,4,6-trimethyl-3-(pyridin-3-yl)phenyl)borane, 1,3-bis[3,5-di(pyridin-3-yl)phenyl]benzene, 3,3',5,5'-tetra[(m-pyridyl)-phen-3-yl]biphenyl, and 1,3,5-tri[(3-pyridyl)-phen-3-yl]benzene,
the acetylene alcohol-based surfactant (143) containing at least one selected from the group consisting of 3-methyl-1-butyn-3-ol, 3-methyl-1-pentyn-3-ol, 3,5-dimethyl-1-hexyn-3-ol, 2,5-dimethyl-3-hexyn-2,5-diol, and 3,6-dimethyl-4-octyn-3,6-diol, and
the solvent containing at least one selected from the group consisting of hexane, heptane, octane, nonane, decane, cyclohexane, xylene, toluene, and tetrahydronaphthalene.

20. The solution according to claim 19, wherein the organic material has a molecular weight of not more than 5000.
